# EUROPÄISCHE PATENTSCHRIFT

(11) **EP 2 263 309 B1**
(45) Veröffentlichungstag und Bekanntmachung des Hinweises auf die Patenterteilung: **06.06.2012**
(21) Anmeldenummer: 09724485.9
(22) Anmeldetag: 14.03.2009
(51) Int. Cl.: H03F 3/189, H03F 1/30

(54) **VERFAHREN ZUR KOMPENSATION VON VERSTÄRKUNGSÄNDERUNGEN BEI EINER VERSTÄRKERSCHALTUNG**
METHOD FOR COMPENSATING AMPLIFICATION VARIATIONS IN AN AMPLIFIER CIRCUIT
PROCÉDÉ POUR COMPENSER DES VARIATIONS D'AMPLIFICATION DANS UN CIRCUIT AMPLIFICATEUR

(30) Priorität: 28.03.2008 DE 102008016154
(43) Veröffentlichungstag der Anmeldung: 22.12.2010
(60) Teilanmeldung: 11001969.2
(73) Patentinhaber: EADS Deutschland GmbH, 85521 Ottobrunn (DE)
(72) Erfinder: SCHROTH, Joerg, 89073 Ulm (DE); REBER, Rolf, 89077 Ulm (DE); RITTMEYER, Rainer, 89081 Ulm (DE); SLEDZIK, Hardy, 89134 Blaustein (DE)
(74) Vertreter: Riegel, Werner
(86) Internationale Anmeldenummer: PCT/DE2009/000355
(87) Internationale Veröffentlichungsnummer: WO 2009/117982

(56) Entgegenhaltungen:
- EP-A- 1 293 798
- EP-A- 1 686 687
- JP-A- 2000 082 928
- US-A1- 2002 158 688
- US-A1- 2004 232 991
- US-A1- 2007 243 846
- US-B1- 6 836 184
- US-B1- 7 103 029

## Beschreibung

Die Erfindung betrifft ein Verfahren zur Kompensation von Verstärkungsänderungen bei einer Verstärkerschaltung.

Schaltungen zur Verarbeitung von HF-Signalen, z.B. in Sende-/Empfangsmodulen für phasengesteuerte Antennen, umfassen üblicherweise GaAs Hochfrequenzbausteine in Form von monolithisch integrierten Mikrowellenschaltungen (MMIC). Die Bauelementeeigenschaften solcher HF-Bauteile sind in der Regel temperaturabhängig, d.h. die elektrischen Eigenschaften der HF-Bauteile variieren in Abhängigkeit der Temperatur. Diese Temperaturabhängigkeit der HF-Bauteile beeinflusst nachhaltig die elektrischen Eigenschaften der Module und Schaltungen, in denen die HF-Bauteile eingebaut sind. GaAs Hochfrequenzbausteine weisen zudem eine Streuung ihrer optimalen Kontrollspannung (z.B. Gate-Spannung) auf und zwar von Wafer zu Wafer und von Los zu Los. Die Anforderungen können von ca -1.0Volt bis 0Volt variieren. Die Bauteile eines Wafers können mit identischer Gate-Spannung betrieben werden wobei jedoch eine Streuung der HF-Eigenschaften von Bauelement zu Bauelement bleibt.

Eine manuelle individuelle Einstellung der Schaltungen oder Module ist zeit- und kostenintensiv und bei hoher Produktionsrate nicht sinnvoll. Es ist daher wünschenswert, das Modul oder die Schaltung so auszulegen, daß Bauteilestreuungen automatisch korrigiert werden (Spreadkompensation) und Temperatureffekte über eine einfache, temperaturabhängige Steuerung weitgehend ausgeglichen werden (Temperaturkompensation).

Aus US 2007/243846 A1 ist ein Verfahren zur Kompensation von Verstärkungsänderungen bei einer Verstärkerschaltung umfassend HF-Bauteilen und Dämpfungsgliedem. Aus US 6,836,184 B1 ist eine Vorrichtung entsprechend des Oberbegriffs des Anspruchs 6 bekannt.

Aus EP 1 293 798 B1 ist eine Schaltung für ein Sende/Empfangs-Modul bekannt, mit der eine stabile und von äußeren Einflüssen nahezu unabhängige Regelung der Ausgangsleistung möglich ist. Dabei wird eine Steuerung der Ausgangsleistung des Sende/Empfangsmoduls durch gezielte Einstellung der Eingangsleistung der Sendekette erreicht, wobei der Gewinn der in der Sendekette vorhandenen Verstärker zur Verstärkung des HF-Sendesignals stets durch eine Regelung konstant gehalten wird. Bei konstantem Gewinn der Verstärker ist die Ausgangsleistung bekannt, wenn die Eingangsleistung mit einem Verstärker mit variabler Verstärkung des Sende/Empfangs-Moduls eingestellt wird.

Aufgabe der Erfindung ist es, ein Verfahren anzugeben, mit welcher eine Kompensation von Bauteilestreuungen und Temperatureffekten bei HF-Bauteilen möglich ist.

Diese Aufgaben werden mit dem Verfahren gemäß den Merkmalen des Anspruchs 1 gelöst. Vorteilhafte Ausführungen der Erfindung sind Gegenstand von Unteransprüchen.

Im Folgenden wird unter einem Dämpfungsglied grundsätzlich ein Verstärker mit variabler Verstärkung und unter einem Hochfrequenzbaustein eine monolithisch integrierten Mikrowellenschaltungen (MMIC) verstanden.

Gemäß dem erfindungsgemäßen Verfahren wird ein Hochfrequenzbaustein mit einer ersten temperaturabhängigen Kontrollspannung U_{HF}(T) und ein Dämpfungsglied mit einer zweiten temperaturabhängigen Kontrollspannung U_{VG}(T) angesteuert. Die erste temperaturabhängige Kontrollspannung U_{HF}(T) wird dabei dadurch erzeugt, dass einer für einen Hochfrequenzbaustein bei einer vorgegebenen Temperatur vorgegebenen individuellen Kontrollspannung Uₒₚₜ zur Einstellung des optimalen Arbeitpunktes des Hochfrequenzbausteins eine Temperaturabhängigkeit aufgeprägt wird. Die zweite temperaturabhängige Kontrollspannung U_{VG}(T) wird dadurch erzeugt, dass einer vorgegebenen Kontrollspannung U_{VG_T} für das Dämpfungsglied eine Temperaturabhängigkeit aufgeprägt wird, wobei die Kontrollspannung U_{VG}__{T} dadurch ermittelt wird, dass in einem Iterationsverfahren die Kontrollspannung U_{VG_T} so eingestellt wird, dass die Ausgangsleistung der Verstärkerschaltung bei konstanter Eingangsleistung einen vorgebbaren Pegel erreicht.

Die erste temperaturabhängige Kontrollspannung U_{HF}(T) basiert auf einer vom Hersteller des Hochfrequenzbauteils angegebenen Spannung. Diese Spannung ist individuell für den jeweils hergestellten Wafer und gibt die individuelle Kontrollspannung Uₒₚₜ zur Einstellung des optimalen Arbeitspunktes für einen Hochfrequenzbaustein dieses Wafers an.

Ein Datenwort, das dieser als individuelle Kontrollspannung Uₒₚₜ bezeichneten Spannung entspricht, wird zweckmäßig in eine erste dem Hochfrequenzbaustein zugeordnete Speichereinrichtung eingelesen. Das Einlesen und Speichern dieses Datenwortes erfolgt zweckmäßig einmalig und dauerhaft bei erstmaliger Durchführung des Verfahrens.

Die Streuung der Eigenschaften der Hochfrequenzbauteile wird durch eine HF-Messung ermittelt und mittels eines spannungsgesteuerten Dämpfungsglieds kompensiert, indem die Spannung U_{VG_T} am Dämpfungsglied in einem Iterationsvertahren variiert wird und somit die Verstärkung so eingestellt wird, bis zwischen Ein- und Ausgang der Verstärkerschaltung die gewünschte Verstärkung erzielt wird. Diese Messung wird zweckmäßig bei einer festen Temperatur z.B. 25°C durchgeführt. Das Datenwort, das dieser ermittelten Kontrollspannung U_{VG_T} entspricht, wird zweckmä-βig in eine zweite, dem Dämpfungsglied zugeordneten Speichereinrichtung eingelesen. Das Einlesen und Speichern des Wertes in der zweiten Speichereinrichtung erfolgt einmalig und dauerhaft bei erstmaliger Durchführung des Verfahrens.

Die Verstärkerschaltung kann eine Kette von Hochfrequenzbausteinen und/oder Dämpfungsglieder enthalten. In diesem Fall wird für jeden Hochfrequenzbaustein das Datenwort für die individuellen Kontrollspannung Uₒₚₜ und für jedes Dämpfungsglied das Datenwort der ermittelten Kontrollspannung U_{VG_T} gespeichert. Die Speicherung erfolgt dabei in Speichereinrichtungen, wobei jedem Hochfrequenzbaustein und jedem Dämpfungsglied vorteilhaft jeweils eine Speichereinrichtung zugeordnet ist.

Erfindungsgemäß wird ein Hochfrequenzbaustein mit einer temperaturabhängigen Kontrollspannung U_{HF}(T) angesteuert, wobei unter Berücksichtigung des abgespeicherten Datenwortes für die Kontrollspannung Uₒₚₜ eine temperaturabhängige Spannung erzeugt wird. Wie der Hochfrequenzbaustein wird auch das Dämpfungsglied, welches zweckmäßig auch ein Verstärker mit variabler Verstärkung sein kann, mit einer temperaturabhängigen Kontrollspannung U_{VG}(T) angesteuert. Dabei wird unter Berücksichtigung des abgespeicherten Datenwortes für die bei dem lterationsverfahren ermittelten Kontrollspannung U_{VG_T} eine temperaturabhängige Spannung erzeugt.

Hierfür sind für jeden HF-Baustein und für jedes Dämpfungsglied jeweils eine elektrische Schaltung mit einem Eingang und einem Ausgang vorgesehen. Am Eingang dieser elektrischen Schaltung liegt ein temperaturabhängiges Eingangssignal U_{IST}(T) an. Das Eingangssignal U_{IST}(T) wird zweckmäßig mittels einer Diode als Temperatursensor und einem der Diode nach geschalteten Operationsverstärker erzeugt. Die elektrische Schaltung erzeugt am Ausgang eine temperaturabhängige Kontrollspannung, wobei einer Spannung eine Temperaturabhängigkeit in Abhängigkeit des Ein gangssignals U_{IST}(T) aufgeprägt wird. Diese Spannung entspricht dabei jeweils dem für ein HF-Bauteil oder Dämpfungsglied gespeicherten Wertes. Diese Temperaturabhängigkeit kann z.B. einen linearen, quadratischen, exponentiellen oder polynomischen Verlauf aufweisen.

Aufgrund der Temperaturabhängigkeit der Kontrollspannung U_{HF}(T) werden temperaturbedingte Änderungen in den Eigenschaften der Hochfrequenzbausteine kompensiert.

Hochfrequenzbauteile können z.B. HF-Verstärkerstufen sein, welche mit einer Gate- oder Basisspannung angesteuert werden. Physikalisch bedingt ändert sich die Verstärkung einer Verstärkerstufe um ca. 0.01 dB/K. Dies bedeutet bei z.B. 5 Stufen und 100K Temperaturänderung eine Verstärkungsänderung von ca. 5dB (linear: Faktor 3). Gewünscht ist etwa 1/10 diese Wertes oder weniger. Gelöst wird dieses Problem durch eine temperaturabhängige Dämpfung des spannungsgesteuerten Dämpfungsgliedes, gerade so, dass die temperaturbedingte Verstärkungsänderung der Hochfrequenzbauteile kompensiert wird.

Die Speichereinrichtungen und elektrischen Schaltungen können in einem digitalen Potentiometer integriert werden. Das digitale Potentiometer weist einen Eingang auf und für jeden Hochfrequenzbaustein und jedes Dämpfungsglied einen Ausgang. Am Eingang liegt die temperaturabhängige Eingangsspannung U_{IST}(T) an und am Ausgang liegt die für das mit dem jeweiligen Ausgang verbundene Hochfrequenzbauteil oder Dämpfungsglied entsprechende Kontrollspannung an. Zweckmäßig werden in der Speichereinrichtung des digitalen Potentiometers die Werte der Spannungsteiler (Teilerverhältnis), die zur Kontrollspannungen Uₒₚₜ für die Hochfrequenzbauteile und zur Kontrollspannungen U_{VG_T} für die Dämpfungsglieder führen, digital gespeichert. Die Erfindung sowie vorteilhafte Ausführungen werden von Figuren näher erfäutert. Es zeigen:
- Fig. 1: eine beispielhafte Vorrichtung für einen Empfangspfad eines Sende-/Empfangsmoduls
- Fig. 2: eine beispielhafte Vorrichtung für einen Sendepfad eines Sende-/Empfangsmoduls

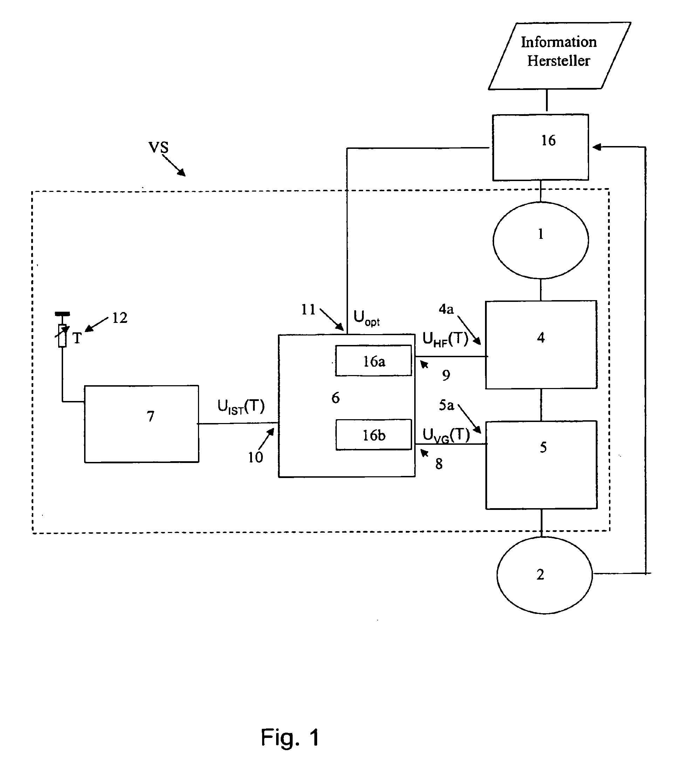

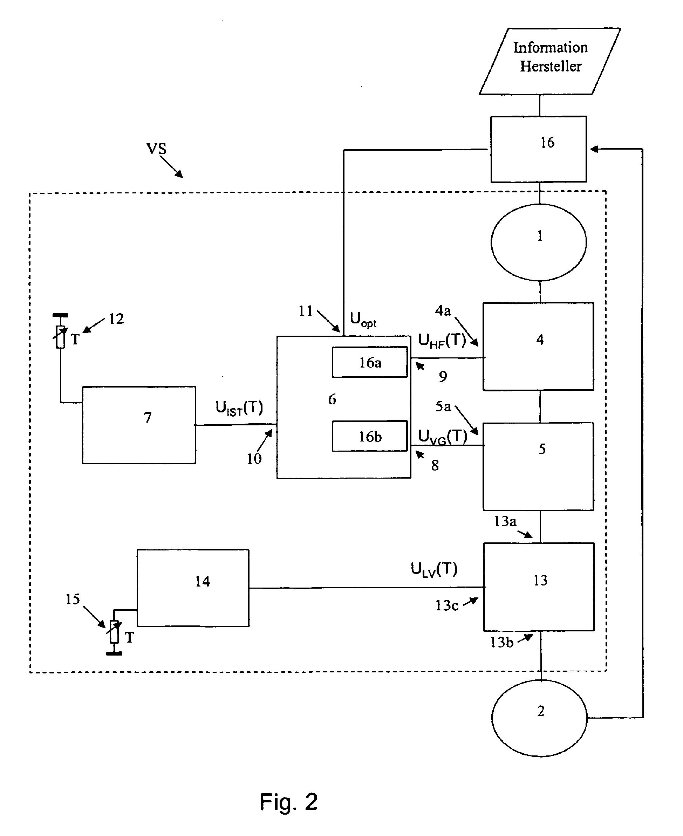

In den Fig. 1 und 2 wird die Erfindung anhand des Sende- und Empfangspfades eines beispielhaften Sende-/Empfangsmoduls näher erläutert.

Die Fig. 1 und 2 zeigen jeweils eine Verstärkerschaltung VS mit einem Eingang 1 und einem Ausgang 2. Der Eingang 1 ist mit einem Hochfrequenzbauteil 4 verbunden. Dieses Hochfrequenzbauteil 4 ist üblicherweise eine Verstärkerstufe. Das Hochfrequenzbauteil 4 ist über ein Dämpfungsglied 5 mit dem Ausgang 2 verbunden. Das HF-Bauteil 4 weist einen Eingang 4a auf, welchem eine temperaturabhängige Kontrollspannung U_{HF}(T) zugeführt ist. Das variable Dämpfungsglied 5 weist einen Eingang 5a auf, welchem eine temperaturabhängige Kontrollspannung U_{VG}(T) zugeführt ist.

Die Verstärkerschaltung VS weist ein digitales Potentiometer 6 mit zweckmäßig integrierten Datenspeichern 16a, 16b auf. Das digitale Potentiometer 6 besitzt einen Eingang 10, an welchem eine temperaturabhängige Eingangsspannung U_{IST}(T) anliegt. Über einen weiteren Eingang 11 können Werte in das digitale Potentiometer 6 eingelesen und in den Datenspeichem 16a, 16b abgespeichert werden.

Die Verstärkerschaltung VS weist zweckmäßig eine Diode 12 als Temperatursensor und einen Steuerverstärker 7, z.B. einen Operationsverstärker, zur Verstärkung der Diodenspannung auf. Mit dieser Anordnung wird am Ausgang des Steuerverstärkers 7 die temperaturabhängige Spannung U_{IST}(T) erzeugt, welche dem Eingang 10 des digitalen Potentiometers 6 zugeführt ist.

Am digitalen Potentiometer 6 sind eine Anzahl von Ausgängen 8, 9 vorhanden, wobei jedes HF-Bauteil 4 und jedes Dämpfungsglied 5 mit genau einem Ausgang 8, 9 verbunden ist. Der Ausgang 8 des Potentiometers 6 ist mit dem Eingang 5a des Dämpfungsgliedes und der Ausgang 9 des Potentiometers 6 ist mit dem Eingang 4a des HF-Bauteils 4 verbunden.

Fig. 2 zeigt den Sendepfad eines beispielhaften Sende-/Empfangsmoduls. Die in Fig. 1 dargestellte Verstärkerschaltung VS ist hierbei um einen am Ausgang 2 (Fig. 1) angeschlossenen Leistungsverstärker 13 erweitert. Der Ausgang 2 der Verstärkerschaltung VS ist somit mit dem Ausgang 13 b des Leistungsverstärkers 13 verbunden. Dieser Leistungsverstärker 13 verstärkt am Ausgang 13b ein am Eingang 13a anliegendes Sendesignal. Über einen weiteren Eingang 13c ist dem Leistungsverstärker 13 eine gepulste temperaturabhängige Steuerspannung U_{LV}(T) zugeführt.

Die Verstärkerschaltung VS umfasst ferner ein Widerstandnetzwerk 14 zur Erzeugung einer temperaturabhängige Steuerspannung U_{LV}(T) für den Ausgangsleistungsverstärker 13. Das Widerstandsnetzwerk 14 umfasst zweckmäßig Widerstände mit negativem Temperaturkoeffizient 15 und eine Zenerdiode.

Zweckmäßig besteht der Ausgangsleistungsverstärker 13 aus einem Leistungsverstärker mit vorgeschaltetem Treiberverstärker (nicht dargestellt). Durch die temperaturabhängige Spannung U_{LV}(T) des Widerstandsnetzwerks wird einerseits die Verstärkung des dem Leistungsverstärker 13 vorgeschalteten Treiberverstärkers (nicht dargestellt) und andererseits die Verstärkung des Leistungsverstärkers 13 selbst beeinflusst. Dazu wird die Kontrollspannung des Treiberverstärkers und des Leistungsverstärkers 13 über der Temperatur so verändert, dass bei höchster Betriebstemperatur die höchste Kontrollspannung anliegt, welche mit abnehmender Temperatur ebenfalls abnimmt. Die Temperaturabhängigkeit wird im Widerstandsnetzwerk 14 über NTCs (Widerstände mit negativem Temperaturkoeffizienten) und Widerstände gesteuert. Dadurch wird der natürlichen Zunahme der Verstärkung bei abnehmenden Temperaturen entgegengewirkt, wodurch die Ausgangsleistung am Ausgang 2 über einen weiten Temperaturbereich konstant gehalten werden kann.

Im Weiteren wird erläutert, wie die Kontrollspannung U_{VG_T} für das Dämpfungsglied ermittelt wird.

Der ermittelte Wert der Kontrollspannung U_{VG}__{T} korrespondiert zu einem vorgebbaren Verhältnis der Ausgangsleistung am Ausgang des Dämpfungsglied 5 zur Eingangsleistung am Eingang 1 der Verstärkerschaltung VS.

Dieser Wert wird bei Inbetriebnahme der Schaltung mittels einer Testeranordnung 16 ermittelt. Die Inbetriebnahme der Schaltung wird zweckmäßig bei einer konstanten Temperatur z.B. 25°C durchgeführt.

Hierbei wird in einem ersten Schritt dem Eingang 11 des digitalen Potentiometers 6 ein digitales Wort (Teilerverhältnis) zugeführt, welches einer dem jeweils verwendeten und vom Potentiometer 6 angesteuerte HF-Bauteil 4 individuellen Spannung Uₒₚₜ entspricht. Diese individuelle Spannung Uₒₚₜ, welche zwischen ca -1.0 bis 0V liegt, ist für das HF-Bauteil herstellungsbedingt gegeben und einem Fachmann bekannt. Das Teilerverhältnis für die Spannung Uₒₚₜ wird in einem im Potentiometer 6 integriertem Speicherbaustein 16a gespeichert. Selbstverständlich kann der Speicherbaustein 16a auch getrennt vom Potentiometer 6 angeordnet sein mit einer elektrischen Verbindung zum Potentiometer 6.

Das digitale Potentiometer 6 erzeugt auf Grund des gespeicherten Teilerverhältnisses und der temperaturabhängigen Spannung U_{IST}(T) am Eingang 10 eine analoge temperaturabhängige Spannung U_{HF}(T) am Ausgang 9, welche als Kontrollspannung dem HF-Bauteil zugeführt wird.

Anschließend werden mittels der Testeranordnung 16 dem Eingang 1 der Verstärkerschaltung VS Testsignale zugeführt und mittels Variation des dem Ausgang 8 zugeordneten Teilerverhältnisses die Kontrollspannung U_{VG_T} am Dämpfungsglied 5 und somit dessen Dämpfung, variiert, bis die gewünschte Verstärkung der Verstär kerschaltung am Ausgang des Dämpfungsglieds 5 erreicht ist. Das resultierende Teilerverhältnis wird in dem zweckmäßig nicht-flüchtigen Speicher 16b im Digitalen Potentiometer 6 gespeichert. Selbstverständlich kann der Speicherbaustein 16b auch getrennt vom Potentiometer 6 angeordnet sein mit einer elektrischen Verbindung zum Potentiometer 6.

Mit der Erfindung wird die bisherige Methode, bei der in jeder Verstärkerschaltung die optimale Spannung Uₒₚₜ durch Löten oder Bonden einer definierten Einstellung eines Widerstandsnetzwerkes bewerkstelligt wird, durch eine elektronische Methode ersetzt. Dies ist ein automatisierter Schritt in einer Automatischen Fertigung. Bisher war dies eine manuelle Tätigkeit.

Die Kompensation der unvermeidlichen Parameterstreuung und der Temperaturabhängigkeit der HF-Bauteile kann entweder durch manuelle Einstellung oder aufwändige Regelung geschehen. Mit der Erfindung werden in einem einmaligen Schritt eine Spannung Uₒₚₜ für das HF-Bauteil und eine Spannung U_{VG}__{T} für das Dämpfungsglied festgelegt, welche dann entsprechend der Temperatur automatisch variiert werden können. Hieraus ergeben sich die Vorteile, dass die HF-Bauteile nicht sehr eng toleriert spezifiziert werden müssen, wodurch sich die Ausbeute beim Hersteller (GaAs Foundry) erhöht. Gleichzeitig können damit die Preise der HF-Bauteile reduziert werden. Ferner kann die Streuung der Verstärkerschaltung VS um einen Faktor von ca. 10 reduziert werden. Dadurch erhöht sich die Fertigungsausbeute der Verstärkerschaltung VS.

Zweckmäßig sind die Speichereinrichtung, elektrische Steuerschaltung und das digitale Potentiometer in einer anwenderspezifisch integrierten Schaltung, einem so genannten ASIC integriert.

## Patentansprüche

1. Verfahren zur Kompensation von Verstärkungsänderungen bei einer Verstärkerschaltung umfassend Hochfrequenzbausteine (4) und Dämpfungsglieder (5), **dadurch gekennzeichnet, dass**
ein Hochfrequenzbaustein (4) mit einer ersten temperaturabhängigen Kontrollspannung U_{HF}(T) und ein Dämpfungsglied (5) mit einer zweiten temperaturabhängigen Kontrollspannung U_{VG}(T) angesteuert werden,
wobei die erste temperaturabhängige Kontrollspannung U_{HF}(T) dadurch erzeugt wird, dass einer für einen Hochfrequenzbaustein (4) bei einer vorgegebenen Temperatur vorgegebenen individuellen Kontrollspannung Uₒₚₜ zur Einstellung des optimalen Arbeitpunktes des Hochfrequenzbausteins (4) eine Temperaturabhängigkeit aufgeprägt wird, und
wobei die zweite temperaturabhängige Kontrollspannung U_{VG}(T) dadurch erzeugt wird, dass einer vorgegebenen Kontrollspannung U_{VG}__{T} für das Dämpfungsglied (5) eine Temperaturabhängigkeit aufgeprägt wird, wobei die Kontrollspannung U_{VG}__{T} dadurch ermittelt wird, dass in einem Iterationsverfahren die Kontrollspannung U_{VG}__{T} so eingestellt wird, dass die Ausgangsleistung der Verstärkerschaltung (VS) bei konstanter Eingangsleistung einen vorgebbaren Pegel erreicht.

2. Verfahren nach Anspruch 1,
**dadurch gekennzeichnet, dass**
der Wert der Kontrollspannung Uₒₚₜ in ein Teilerverhältnis umgerechnet wird und in eine erste Speichereinrichtung (16a) gelesen wird.

3. Verfahren nach Anspruch 1 oder 2,
**dadurch gekennzeichnet, dass**
der dem Verhältnis von Ausgangsleistung zu Eingangsleistung der Verstärkerschaltung entsprechende Wert der ermittelten Kontrollspannung U_{VG}__{T} in ein Teilerverhältnis umgerechnet wird und in eine zweite Speichereinrichtung (16b) gelesen wird.

4. Verfahren nach Anspruch 1,
**dadurch gekennzeichnet, dass**
ein Leistungsverstärker (13) mit einer temperaturabhängigen Kontrollspannung U_{LV}(T) angesteuert wird.

5. Verfahren nach Anspruch 4,
**dadurch gekennzeichnet, dass**
der Leistungsverstärker (13) mit einer gepulsten Kontrollspannung U_{LV}(T) angesteuert wird.

## Claims

1. Method for compensating for gain changes in an amplifier circuit, comprising radio-frequency modules (4) and attenuation elements (5),
**characterized in that**
a radio-frequency module (4) is driven with a first temperature-dependent monitoring voltage U_{HF}(T), and an attenuation element (5) with a second temperature-dependent monitoring voltage U_{VG}(T), wherein the first temperature-dependent monitoring voltage U_{HF}(T) is produced by applying a temperature dependency to an individual monitoring voltage Uₒₚₜ, which is predetermined for a predetermined temperature for a radio-frequency module (4), in order to set the optimum operating point of the radio-frequency module (4), and
wherein the second temperature-dependent monitoring voltage U_{VG}(T) is produced by applying a temperature dependency to a predetermined monitoring-voltage U_{VG}__{T} for the attenuation element (5), wherein the monitoring voltage U_{VG_T} is determined by setting the monitoring voltage U_{VG_T} in an iteration method such that the output power of the amplifier circuit (VS) reaches a predeterminable level at a constant input power.

2. Method according to Claim 1,
**characterized in that**
the value of the monitoring voltage Uₒₚₜ is converted to a division ratio, and is read to a first memory device (16a).

3. Method according to Claim 1 or 2,
**characterized in that**
the value of the determined monitoring voltage U_{VG_T} which corresponds to the ratio of the output power to the input power of the amplifier circuit is converted to a division ratio, and is read to a second memory device (16b).

4. Method according to Claim 1,
**characterized in that**
a power amplifier (13) is driven with a temperature-dependent monitoring voltage U_{LV}(T).

5. Method according to Claim 4,
**characterized in that**
the power amplifier (13) is driven with a pulsed monitoring voltage U_{LV}(T).

## Revendications

1. Procédé de compensation des variations de l'amplification sur un circuit d'amplification comprenant des composants à haute fréquence (4) et des éléments atténuateurs (5), **caractérisé en ce**
**qu'**un composant à haute fréquence (4) est commandé avec une première tension de contrôle U_{HF}(T) dépendante de la température et un élément atténuateur (5) avec une deuxième tension de contrôle U_{VG}(T) dépendante de la température,
la première tension de contrôle U_{HF}(T) dépendante de la température étant générée en ce que, pour un composant à haute fréquence (4), une dépendance à la température est appliquée à une tension de contrôle Uₒₚₜ individuelle prédéfinie à une température prédéfinie destinée à régler le point de fonctionnement optimal du composant à haute fréquence (4), et
la deuxième tension de contrôle U_{VG}(T) dépendante de la température étant générée en ce qu'une dépendance à la température est appliquée à une tension de contrôle U_{VG_T} prédéfinie pour l'élément atténuateur (5), la tension de contrôle U_{VG_T} étant déterminée en réglant la tension de contrôle U_{VG_T} dans un procédé d'itération de telle sorte que la puissance de sortie du circuit d'amplification (VS) atteint un niveau pouvant être prédéfini pour une puissance d'entrée constante.

2. Procédé selon la revendication 1, **caractérisé en ce que** la valeur de la tension de contrôle Uₒₚₜ est convertie en un rapport partiel et lue dans un premier dispositif de mémorisation (16a).

3. Procédé selon la revendication 1 ou 2, **caractérisé en ce que** la valeur de la tension de contrôle U_{VG_T} déterminée correspondant au rapport entre la puissance de sortie et la puissance d'entrée du circuit d'amplification est convertie en un rapport partiel et lue dans un deuxième dispositif de mémorisation (16b).

4. Procédé selon la revendication 1, **caractérisé en ce qu'**un amplificateur de puissance (13) est commandé avec une tension de contrôle U_{LV}(T) dépendante de la température.

5. Procédé selon la revendication 4, **caractérisé en ce que** l'amplificateur de puissance (13) est commandé avec une tension de contrôle U_{LV}(T) impulsionnelle.
